## Europäisches Patentamt

## European Patent Office

## Office européen des brevets

(19)

(11) Publication number: **0 006 725**
**B1**

(12) **EUROPEAN PATENT SPECIFICATION**

(45) Date of publication of patent specification: **15.12.82**

(51) Int. Cl.³: **H 01 R 23/00**

(21) Application number: **79301163.6**

(22) Date of filing: **18.06.79**

(54) Electrical connector for connecting a flat cable to a substrate.

| | |
|---|---|
| (30) Priority: **22.06.78 US 918139**<br>**23.10.78 US 953677**<br>**02.03.79 US 16864**<br>**27.03.79 US 24356** | (73) Proprietor: **AMP INCORPORATED**<br>**Eisenhower Boulevard**<br>**Harrisburg, Pennsylvania (US)** |
| (43) Date of publication of application:<br>**09.01.80 Bulletin 80/1** | (72) Inventor: **Olsson, Billy Erik**<br>**709 Drexel Hills Boulevard**<br>**New Cumberland Pennsylvania (US)** |
| (45) Publication of the grant of the patent:<br>**15.12.82 Bulletin 82/50** | (74) Representative: **Stuart-Prince, Richard Geoffrey**<br>**et al,**<br>**20 Queensmere**<br>**Slough, Berkshire SL1 1YZ (GB)** |
| (84) Designated Contracting States:<br>**AT BE CH DE FR GB IT NL SE** | |
| (56) References cited:<br>**none** | |

Courier Press, Leamington Spa, England.

Electrical connector for connecting a flat cable to a substrate

This invention relates to an electrical connector, and particularly an electrical connector for use in establishing electrical connections between the conductors of a flat multi-conductor electrical cable and conductors carried by a substrate.

Such a connector is disclosed in French Patent Application No. 73.14613, publication No. FR—A—2241888, which discloses a connector comprising a single member stamped and formed from sheet metal and having an elongate body portion, a plurality of resilient contact fingers arranged in a row extending lengthwise of the body portion, all the fingers extending in the same direction and having their longitudinal axes extending transversely of the row direction, and mounting means formed at each end of the body portion and adapted and arranged to secure the connector to a substrate with the fingers extending towards and engaging conductors carried by the substrate.

For use of this known connector, exposed end portions of the conductors of a flat multi-conductor cable comprising a plurality of parallel conductors carried by a sheet of insulating material, are clamped between the fingers and conductors on the surface of a substrate, for example a printed circuit board, the fingers thus serving to urge the cable conductors into engagement with the substrate conductors respectively, to provide the required connections.

With this known connector the fingers are arranged to point away from the edge of the substrate at which the connector is to be mounted, that is towards the cable to be connected to the substrate, and thus the connector can be mounted only at an edge of a substrate with the cable and connector being simultaneously applied to the substrate with the mounting means of the connector entering slots open to the edge of the substrate. This is because if the connector is first mounted onto the substrate without the cable, then the end of cable cannot subsequently be inserted between the fingers and the substrate since the free ends of the fingers are directed towards the cable and are in engagement with the substrate.

This known connector thus has the disadvantages that as disclosed it can be used only at an edge of a substrate, and must be assembled to a substrate simultaneously with a cable, and must also be removed from the substrate when the cable is to be removed.

U.S. Patent Specification No. US—A—3629787 discloses an electrical connector which serves the same purpose as the connector discussed above, and which comprises a housing of insulating material adapted to be secured to an end of a substrate having conductors on a surface thereof, the housing containing a contact structure stamped and formed from sheet metal and comprising a plurality of resilient fingers extending from one edge of a body portion, the fingers being reversely bent to underlie the body portion. In use, the housing is secured to the substrate with exposed end portions of the conductors of a cable as described above positioned between the conductors on the substrate and the fingers such that the fingers are compressed and serve to urge the cable conductors into engagement with the substrate conductors to provide the required connections.

This known connector has the disadvantages that it consists of a plurality of different parts which must be assembled together, and that no provision is made for zero force insertion of a cable end between the fingers and the substrate if the connector is mounted on the substrate prior to insertion of the cable end.

According to this invention there is provided an electrical connector for use in establishing electrical connections between the conductors of a flat multi-conductor electrical cable and conductors carried by a substrate, the connector comprising a single member stamped and formed from sheet metal and having an elongate body portion, a plurality of resilient contact fingers arranged in a row extending lengthwise of the body portion, all the fingers extending in the same direction and having their longitudinal axes extending transversely of the row direction, and mounting means formed at each end of the body portion and adapted and arranged to secure the connector to a substrate with the fingers extending towards and engaging conductors carried by the substrate, characterised in that the fingers extend from one longitudinal edge of the body portion and are reversely bent to underlie the body portion, each finger being bent to present a rounded surface in a direction away from the body portion for engagement with a conductor carried by the substrate, and is then extended to provide a tail portion which, when the connector is mounted on the substrate extends in a spaced relationship from the substrate, the mounting means being formed on flanges extending from the ends of the body portion and to the same side as the fingers, end portions of the flanges adjacent tail portions of the fingers being bent inwardly towards each other so as to be suitable to serve as pivot points for a tool engageable under the tail portions such that pivoting movement of the tool on the end portions effects lifting of the fingers away from the substrate.

The connector of this invention has the advantages that it is cheap and simple to manufacture, can easily be mounted on a substrate at any required position not needing to be at an edge of the substrate, provides for zero force insertion of a cable end between the fingers and a substrate on which the connector is mounted, and does not have to be disassembled in any way when the cable is to be removed.

U.S. Patent Specification No. US—A 3082398 discloses a contact finger structure somewhat similar in appearance to that of the connector of this invention. However, the finger structure of this prior specification is not used in the manner of the connector of this invention to provide zero force connection of a flat cable to conductors on a substrate, but is used supported by an insulating body and with a flat cable wrapped about the structure to provide a spring plug arrangement.

This invention will now be described by way of example with reference to the drawings, in which:—

Figure 1 is a perspective view of an electrical connector according to this invention in use in connecting the conductors of a flat multi-conductor electrical cable to respective conductors on a substrate;

Figure 2 is a section on the line II—II in Figure 1 but with the cable removed;

Figures 3 and 4 are views similar to Figure 2 but showing two stages in the introduction of a cable to be connected to the substrate;

Figure 5 is a view similar to Figure 2 but of a modified connector according to this invention;

Figure 6 is a view similar to Figure 2 but showing the connector in an assembly connecting the conductors of the cable to conductors on the surface of the substrate remote from the connector;

Figure 7 is a view similar to Figure 6 but showing a modified connector according to this invention, and with the cable removed from the assembly;

Figure 8 is a view in the direction of the arrows VIII—VIII in Figure 7;

Figure 9 is a view similar to Figure 1 but showing another modified form of connector according to this invention;

Figure 10 is a section on the line X—X in Figure 9 but with the cable removed; and

Figure 11 is a view in the direction of the arrows XI—XI in Figure 10.

The same reference numerals have been used for corresponding integers throughout the drawings.

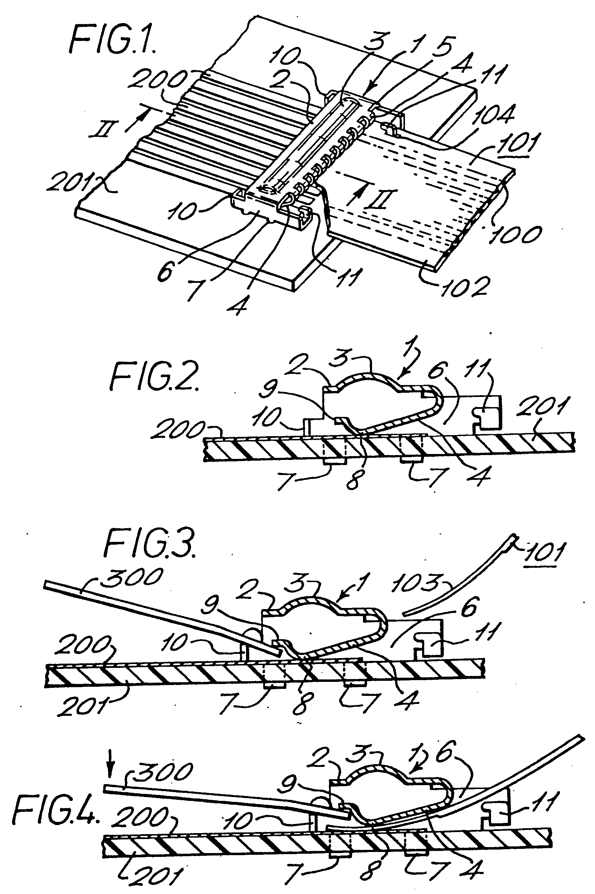

The connector 1 shown in Figures 1 and 2 comprises a single member stamped and formed from sheet metal and having an elongate body portion 2 formed with a longitudinally extending strengthening embossment 3. A plurality of resilient contact fingers 4 extend from one longitudinal edge 5 of the body portion 2, the fingers 4 being in a row extending lengthwise of the body portion 2 with all the fingers 4 extending in the same direction and having their longitudinal axes extending transversely of the row direction. Each finger 4 is reversely bent to underlie the body portion 2, as clearly shown in Figure 2.

Each end of the body portion 2 is formed with mounting means in the form of a flange 6 extending from the end of the body portion 2 and to the same side of the body portion 2 as the fingers 4, the free edge of the flange 6 remote from the body portion 2 being formed with two tabs 7.

Figure 1 shows the connector 1 in use in establishing connections between the conductors 100 of a flat multi-conductor electrical cable 101 in which the conductors 100 are encased in a sheet of insulating material 102, and conductors 200 on a substrate 201 such as a printed circuit board.

The connector 1 is mounted on the substrate 201 by the tabs 7 being passed through respective holes in the substrate 201 and then being bent to engage the surface of the substrate 201 remote from the surface carrying the conductors 200, as shown in Figure 2, the free edges of the flanges 6 engaging the substrate 201. When the connector 1 is so mounted the fingers 4 resiliently engage respective conductors 200 on the substrate 201, as shown in Figure 2. The free end of each finger 4 is bent back towards the body portion 2 to present a rounded surface 8 to the substrate 201, and is then bent again to provide a short tail portion 9 which, when the connector 1 is mounted on the substrate 201, extends substantially parallel to and spaced from the surface of the substrate 201.

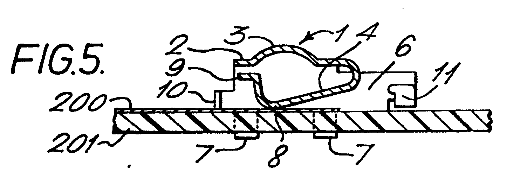

Referring now to Figures 3 and 4 also, to connect the conductors 100 of the cable 101 to the conductors 200 on the substrate 201, the insulation 102 is removed from one side of the cable over an end portion 103 thereof, as shown in Figures 3 and 4, to expose the conductors 100.

End portions 10 of the flanges 6 adjacent the free ends of the fingers 4 are bent inwardly towards each other, and serve as pivot points for a tool 300 such as a sheet of metal, which is inserted under the tail portions 9 of the fingers 4 and over the pivot points 10 as shown in Figure 3. Pressure on the outer end of the tool 300 towards the substrate 201 causes the tool 300 to lift the fingers 4 out of engagement with the conductors 200 on the substrate 201, as shown in Figure 4, whereby the treated end portion 103 of the cable 101 can be inserted between the fingers 4 and the conductors 200, with the exposed conductors 100 of the cable 101 facing and respectively aligned with the conductors 200. The tool 300 is then removed, and the fingers 4 resiliently engage the still insulated side of the end portion 103 of the cable 101 and urge the conductors 100 of the cable 101 into electrical contact with respective ones of the conductors 200 on the substrate 201.

Use of the tool 300 is often not essential since the fingers 4 and associated conductors 200 on the substrate 201 together define a tapering insertion mouth for the cable end portion 103 which can therefore be just pushed in between the fingers 4 and conductors 200, moving the fingers 4 as necessary during such insertion.

Portions of the flanges 6 of the connector at the ends of the flanges 6 adjacent the roots of the fingers 4 are bent first inwardly towards each other and then bent again to extend away from the substrate 201 to provide hook portions 11 facing the fingers 4. The cable 101 has two holes 104 (Figure 1) formed therein, the holes 104 being positioned to receive the hook portions 11 of the connector 1 when the cable is inserted between the fingers 4 and the substrate 201, as shown in Figure 1, thereby to restrain the cable 101 from being pulled from the connector 1.

Referring now to Figure 5, the connector 1 here shown is similar to that shown in Figures 1 to 4, the only difference being that the fingers 4 are overall longer, and are such that the tail portion 9 of each finger 4 is positioned to limit the possible deflection of the finger 4 towards the body portion 2 to an extent ensuring that the finger cannot be overstressed such that the resiliency properties thereof are damaged.

The connector 1 shown in Figure 6 is the same as that shown in Figures 1 to 4 save for a difference in the shape of the strengthening embossment 3. However, the connector 1 is shown mounted on the side of the substrate 201 remote from the conductors 200 carried by the substrate 201. In this assembly connections between the conductors 200 on the substrate and the conductors 100 of the cable 101 are established by way of L-shaped contact members 500 each having one limb extending across the surface of the substrate 201 on which the connector 1 is mounted, and the other limb extending through a hole in the substrate 201 and connected as by solder to a respective conductor 200. The fingers 4 of the connector 1 serve to urge the conductors 100 of the cable 101 into engagement with respective ones of the contact members 500 whereby the required connections are established.

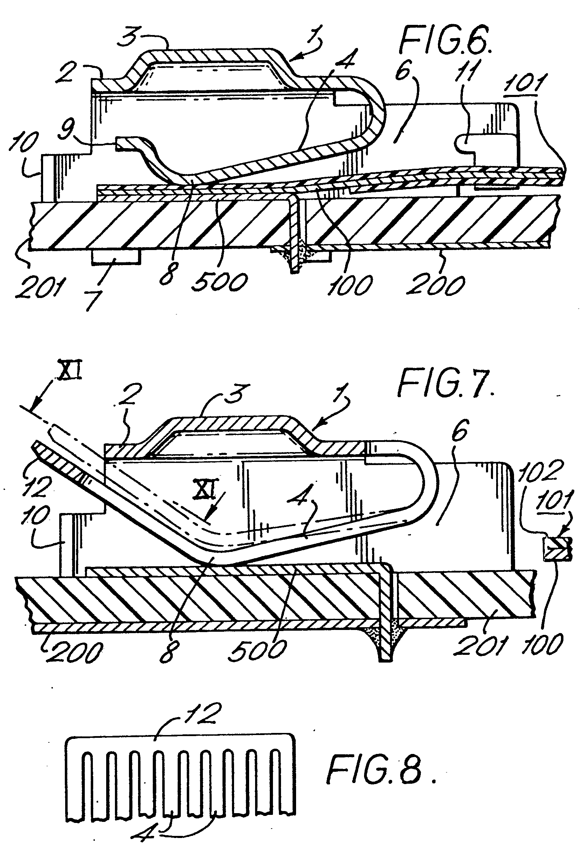

Referring now to Figures 7 and 8, the connector 1 here shown is similar to that shown in the Figure 6 assembly, save that the strain relief hook portions 11 are omitted, and the fingers 4 are of such a length to extend beyond the body portion 2 so as to be accessible to the hand of a user of the connector. Further, as shown in Figure 8, the "free" ends of the fingers 4 are joined by an integrally formed cross-member 12.

With this connector the fingers 4 can be lifted out of engagement with the substrate 201 for insertion of the cable 101 without the use of a tool (e.g. 300 in Figures 3 and 4) simply by manual action on the cross-member 12.

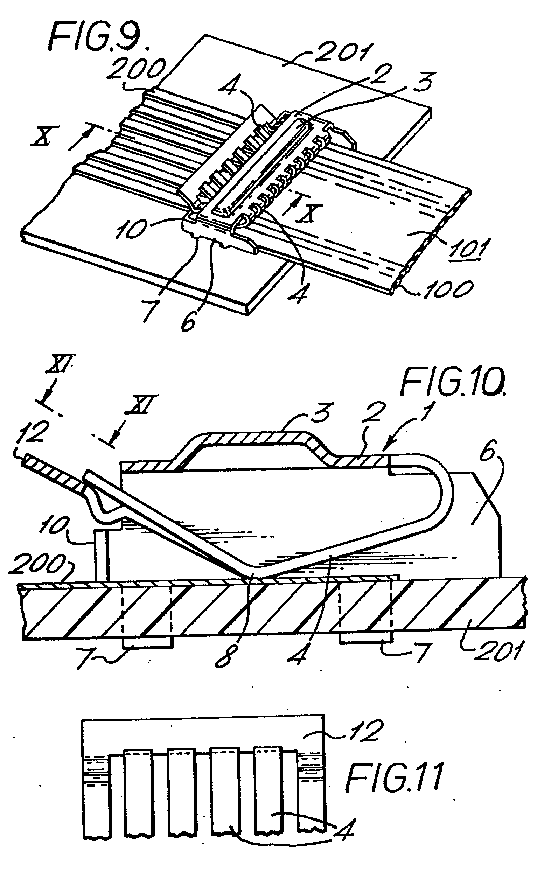

Referring now to Figures 9, 10 and 11, the connector here shown is similar to that shown in Figures 1 to 4 save that the hook portions 11 are omitted, and the fingers 4 are of such a length to extend beyond the body portion 2 of the connector 1. The connector 1 also includes a cross-member 12 similar to that shown in Figures 7 and 8, the difference being that this cross-member is joined to the "free" ends of only the end fingers 4, which end fingers 4 are bent, as shown in Figure 10, such that the cross-member 12 engages under the free ends of the remaining fingers 4, as clearly shown in Figure 11.

With this connector 1 the fingers 4 can be lifted out of engagement with the substrate 201 by manual action on the cross-member 12, for insertion of a cable between the fingers 4 and the substrate 201.

## Claims

1. An electrical connector for use in establishing electrical connections between the conductors of a flat multi-conductor electrical cable and conductors carried by a substrate, the connector comprising a single member stamped and formed from sheet metal and having an elongate body portion, a plurality of resilient contact fingers arranged in a row extending lengthwise of the body portion, all the fingers extending in the same direction and having their longitudinal axes extending transversely of the row direction, and mounting means formed at each end of the body portion and adapted and arranged to secure the connector to a substrate with the fingers extending towards and engaging conductors carried by the substrate, characterised in that the fingers (4) extend from one longitudinal edge (5) of the body portion (2) and are reversely bent to underlie the body portion (2), each finger (4) being bent to present a rounded surface (8) in a direction away from the body portion (2) for engagement with the conductors (200) carried by the substrate (201), and is then extended to provide a tail portion (9) which, when the connector is mounted on the substrate (201), extends in a spaced relationship from the substrate, the mounting means being formed on flanges (6) extending from the ends of the body portion (2) and to the same side as the fingers (4), end portions (10) of the flanges (6) adjacent tail portions (9) of the fingers (10) being bent inwardly towards each other so as to be suitable to serve as pivot points for a tool (300 figures 3 and 4) engageable under the tail portions (9) such that pivoting movement of the tool (300) on the end portions (10) effects lifting of the fingers (10) away from the substrate (201).

2. A connector as claimed in claim 1, characterised in that end ones of the fingers (4) are integrally joined by a cross-member (12) underlying tail portions (9) of the intermediate fingers (8).

3. A connector as claimed in claim 1, characterised in that tail portions (9) of the fingers (8) are integrally joined by a cross-member (12 figure 10).

4. A connector as claimed in claim 1, characterised in that tail portions (9) of the fingers (8) are disposed below an overlying part of the body portion (2 figure 5) arranged to limit deflection of the fingers (8) away from the substrate (201).

5. A connector as claimed in claim 1, characterised in that portions of the flanges (6) at ends of the flanges opposite the end portions (10) are bent inwardly and are formed as hook portions (11) adapted to engage holes (104) in a cable (101) extending from between the fingers (8) and the substrate (201) to serve as strain relief against pulling forces on the cable (101).

**Revendications**

1. Connecteur électrique à utiliser pour établir des connexions électriques entre les conducteurs d'un câble électrique plat à conducteurs multiples et des conducteurs portés par un substrat, le connecteur comprenant un élément unique embouti et formé en métal en feuille et ayant un corps allongé, plusieurs lames élastiques de contact agencées en une rangée s'étendant longitudinalement au corps, toutes les lames s'étendant dans la même direction et ayant leurs axes longitudinaux s'étendant transversalement à la direction de la rangée, et des moyens de montage formés à chaque extrémité du corps et conçus et agencés pour fixer le connecteur à un substrat, les lames s'étendant vers et portant contre les conducteurs portés par le substrat, caractérisé en ce que les lames (4) partent d'un bord longitudinal (5) du corps (2) et sont repliées en arrière pour s'étendre au-dessous du corps (2), chaque lame (4) étant pliée pour présenter une surface arrondie (8) dans une direction s'éloignant du corps (2) pour le contact avec les conducteurs (200) portés par le substrat (201), et étant ensuite prolongée pour former un tronçon de queue (9) qui, lorsque le connecteur est monté sur le substrat (201), s'étend à distance du substrat, les moyens de montage étant formés sur des rebords (6) qui partent des extrémités du corps (2) et sur le même côté que les lames (4), des parties extrêmes (10) des rebords (6), adjacentes aux tronçons de queue (9) des lames (10), étant pliées vers l'intérieur et l'une vers l'autre de manière à pouvoir servir de points de pivotement pour un outil (par exemple 300 sur les figures 3 et 4) pouvant être engagé sous les tronçons de queue (9) de manière qu'un mouvement de pivotement de l'outil (300) sur les parties extrêmes (10) ait pour effet de soulever les lames (10) du substrat (201).

2. Connecteur selon la revendication 1, caractérisé en ce que les lames (4) situées aux extrémités sont reliées entre elles par un élément transversal (12) s'étendant au-dessous des tronçons de queue (9) des lames intermédiaires (8).

3. Connecteur selon la revendication 1, caractérisé en ce que les tronçons de queue (9) des lames (8) sont reliés les uns aux autres par un élément transversal (12 sur la figure 10).

4. Connecteur selon la revendication 1, caractérisé en ce que les tronçons de queue (9) des lames (8) sont disposés au-dessous d'une partie surjacente du corps (2 sur la figure 5) agencée pour limiter la flexion des lames (8) à l'écart du substrat (201).

5. Connecteur selon la revendication 1, caractérisé en ce que des parties des rebords (6) situées aux extrémités des rebords opposées aux parties extrêmes (10) sont pliées vers l'intérieur et sont formées en crochets (11) destinés à s'enclencher dans des trous (104) d'un câble (101) partant d'entre les lames (8) et le substrat (201) pour assumer une fonction de soulagement de contrainte envers des forces de traction exercées sur le câble (101).

**Patentansprüche**

1. Ein elektrischer Verbinder zur Benutzung bei der Herstellung elektrischer Verbindungen zwischen den Leitern eines elektrischen Mehrfachleiter-Flachkabels und von einem Substrat getragenen Leitern, der ein aus Metallblech gestanztes und geformtes Einzelglied aufweist, welches einen länglichen Körper, eine Vielzahl federnd nachgiebiger Kontaktfinger, die in einer sich in Längsrichtung des Körpers erstreckenden Reihe angeordnet sind und alle in die gleiche Richtung weisen und mit ihren Längsachsen quer zur Reihenrichtung liegen, und Halterungsmittel besitzt, die an jedem Ende des Körpers ausgebildet und geeignet und so angeordnet sind, daß sie den Verbinder an einem Substrat so befestigen, daß sich die Finger zu vom Substrat getragenen Leitern erstrecken und mit diesen in Eingriff stehen, dadurch gekennzeichnet, daß die Finger (4) sich von einer Längskante (5) des Körpers (2) erstrecken und so zurückgebogen sind, daß sie unter dem Körper (2) liegen, daß jeder Finger (4) so gebogen ist, daß er eine abgerundete Oberfläche (8) in einer Richtung vom Körper (2) weg zum Eingriff mit den vom Substrat (201) getragenen Leitern (200) darbietet, und dann verlängert ist, um einen Schwanzbereich (9) zu bieten, der sich, wenn der Verbinder am Substrat (201) angebracht ist, im Abstand vom Substrat erstreckt, daß die Halterungsmittel an Flanschen (6) ausgebildet sind, die sich von den Enden des Körpers (2) und zur gleichen Seite wie die Finger (4) erstrecken, daß Schwanzbereichen (9) der Finger (4) benachbarte Endbereiche (10) der Flansche (6) nach innen zueinander so gebogen sind, daß sie geeignet sind, als Schwenkpunkte für ein Werkzeug (300 in Fig. 3 und 4) zu dienen, welches so unter die Schwanzbereiche (9) in Eingriff bringbar ist, daß eine Schwenkbewegung des Werkzeugs (300) an den Endbereichen (10) bewirkt, daß die Finger (4) vom Substrat (201) abgehoben werden.

2. Ein Verbinder nach Anspruch 1, dadurch gekennzeichnet, daß endständige Finger (4) durch ein Querteil (12) einstückig miteinander verbunden sind, welches unter den Schwanzbereichen (9) der Zwischenfinger (8) liegt.

3. Ein Verbinder nach Anspruch 1, dadurch gekennzeichnet, daß Schwanzbereiche (9) der Finger (8) durch ein Querteil (12 Fig. 10) einstückig vereinigt sind.

4. Ein Verbinder nach Anspruch 1, dadurch gekennzeichnet, daß Schwanzbereiche (9) der Finger (8) unterhalb eines ihnen überlagerten Teils des Körpers (2 Fig. 5) vorgesehen und so angeordnet sind, daß sie Ablenkungen der Finger (8) vom Substrat (201) weg begrenzen.

5. Ein Verbinder nach Anspruch 1, dadurch gekennzeichnet, daß Teile der Flansche (6) an den den Endbereichen (10) gegenüberliegenden Enden der Flansche nach innen gebogen und als Hakenbereiche (11) ausgebildet sind, die zum Eingriff mit Löchern (104) in einem sich von zwischen den Fingern (8) und dem Substrat (201) erstreckenden Kabel (101) geeignet sind, um als Spannungsentlastung gegen Zugkräfte auf das Kabel (101) zu dienen.

FIG.1.

FIG.2.

FIG.3.

FIG.4.

FIG.5.

FIG.6.

FIG.7.

FIG.8.

FIG.9.

FIG.10.

FIG.11